# EUROPÄISCHE PATENTSCHRIFT

(11) **EP 3 048 653 B1**
(45) Veröffentlichungstag und Bekanntmachung des Hinweises auf die Patenterteilung: **11.09.2019**
(21) Anmeldenummer: 16150995.5
(22) Anmeldetag: 13.01.2016
(51) Int. Cl.: H01L 43/14, H01L 21/56, B29C 45/14, G01R 33/00, G01R 33/07, H01L 43/06, H01L 43/12, H01L 25/16, H01L 43/04

(54) **VERFAHREN ZUR HERSTELLUNG VON STROMSENSOREN**
METHOD OF MAKING CURRENT SENSORS
PROCEDE DE FABRICATION DE CAPTEURS DE COURANT

(30) Priorität: 22.01.2015 CH 792015
(43) Veröffentlichungstag der Anmeldung: 27.07.2016
(73) Patentinhaber: Melexis Technologies SA, 2022 Bevaix (CH)
(72) Erfinder: RACZ, Robert, 6300 Zug (CH); CHEN, Jian, Heist op den Berg 2220 (BE)
(74) Vertreter: Falk, Urs

(56) Entgegenhaltungen:
- US-A1- 2004 080 308
- US-A1- 2005 161 809
- US-A1- 2008 237 818
- US-A1- 2013 020 660

## Beschreibung

### Gebiet der Erfindung

Die Erfindung betrifft ein Verfahren zur Herstellung von Stromsensoren, die ein in der IC Technologie hergestelltes Kunststoffgehäuse mit aus dem Gehäuse herausragenden elektrischen Anschlüssen und einen aus dem Gehäuse herausragenden Stromleiter umfassen, durch den der zu messende Strom fliesst.

### Stand der Technik

Aus der US 20040080308 sind ein Stromsensor und ein Verfahren zu dessen Herstellung bekannt, bei dem der Stromleiter lose durch eine Öffnung im Gehäuse des Stromsensors geführt ist. Als Messelement wird ein Hallsensor verwendet, der entweder mit den anderen Bauteilen direkt in das Gehäuse eingegossen wird, oder zuerst in ein Gehäuse verkapselt und dann mit den anderen Bauteilen in das Gehäuse des Stromsensors eingegossen wird.

Aus der US 2013/020660 ist ein Stromsensor bekannt, dessen Stromleiter aus dem gleichen Material wie die elektrischen Anschlüsse besteht. Der Stromsensor weist eine verstärkte Isolation auf.

Aus der US 2008/237818 ist ein Verfahren zur Herstellung eines integrierten Schaltkreises bekannt, bei dem ein mehrstufiger Verkapselungsprozess verwendet wird, um die Bonddrähte zu schützen.

### Kurze Beschreibung der Erfindung

Die Erfindung besteht in den in den Ansprüchen 1 und 4 angegebenen Merkmalen. Weiterbildungen der Erfindung ergeben sich aus den abhängigen Ansprüchen.

### Kurze Beschreibung der Figuren

Die beigefügten Zeichnungen, die in die Beschreibung einbezogen sind und einen Teil dieser Beschreibung bilden, veranschaulichen eine oder mehrere Ausführungsformen der vorliegenden Erfindung und dienen zusammen mit der detaillierten Beschreibung dazu, die Prinzipien und die Ausführungsformen der Erfindung zu erläutern. Die Figuren sind nicht massstabsgetreu gezeichnet. In den Zeichnungen
- Fig. 1 bis 5: zeigen verschiedene Momentaufnahmen des erfindungsgemässen Herstellungsverfahrens, und
- Fig. 6: zeigt in perspektivischer Ansicht einen mit diesem Verfahren hergestellten Stromsensor.

### Detaillierte Beschreibung der Erfindung

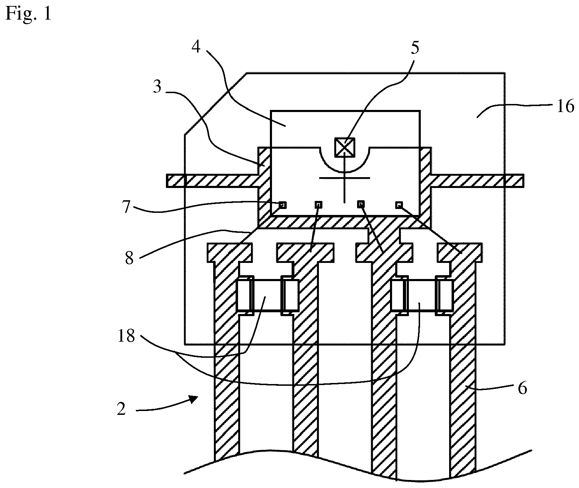

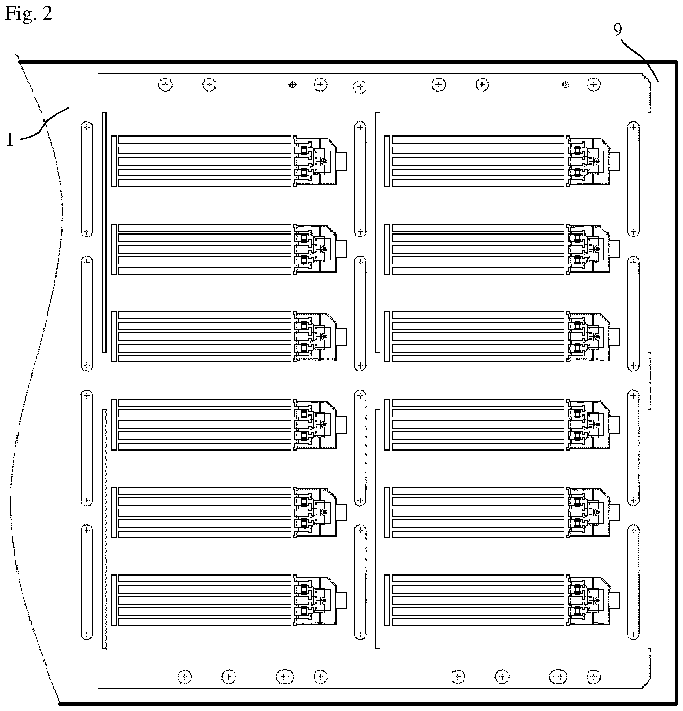

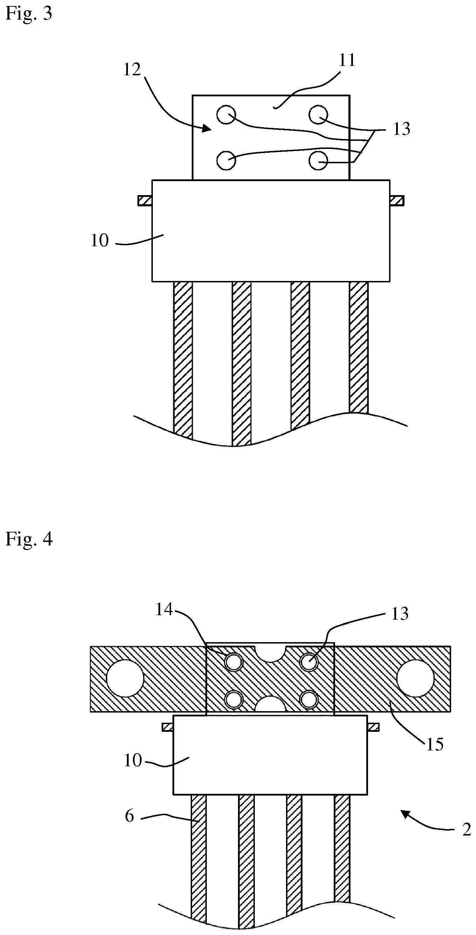

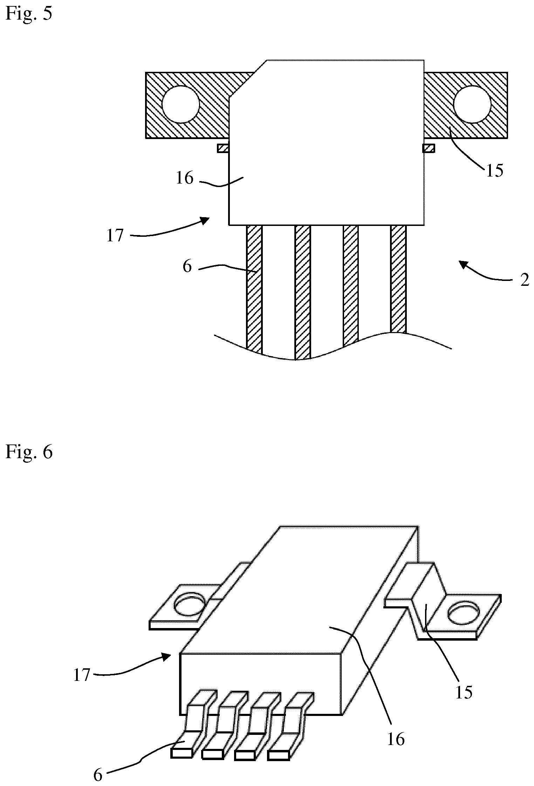

Ein erstes erfindungsgemässes Verfahren zur Herstellung von Stromsensoren umfasst die nachfolgend erläuterten Schritte Abis K und wird anhand der Fig. 1 bis 5 erläutert, die in Aufsicht Momentaufnahmen zeigen. Die Fig. 1 zeigt den Zustand nach dem Schritt B. Die Fig. 2 zeigt den Zustand nach dem Schritt C. Die Fig. 3 zeigt den Zustand nach dem Schritt F. Die Fig. 4 zeigt den Zustand nach dem Schritt G. Die Fig. 5 zeigt den Zustand nach dem Schritt J. Die Fig. 6 zeigt in perspektivischer Ansicht einen mit diesem Verfahren hergestellten Stromsensor.

Ausgangspunkt des Verfahrens ist ein Leadframe 1, das eine Vielzahl von gleichen Leadframeabschnitten 2 enthält, aus denen je ein Stromsensor gebildet wird. Jeder Leadframeabschnitt 2 enthält eine Chip-Auflagefläche 3 für einen Halbleiterchip 4 mit einem oder mehreren integrierten Hallsensor(en) 5, sowie elektrische Anschlussfinger 6. Die Fig. 1, 2, 4 und 5 zeigen nur Teile eines einzigen Leadframeabschnitts 2, wobei diese Teile schraffiert dargestellt und wie üblich mit dem nicht gezeigten Rahmen des Leadframes 1 (bzw. einfach mit dem Leadframe 1) verbunden sind.

Das erste Verfahren umfasst die Verfahrensschritte A bis K, die in der nachfolgend angegebenen Reihenfolge ausgeführt werden:
A) Bereitstellen eines Leadframes mit Chip-Auflageflächen 3 und Montieren eines Halbleiterchips 4 mit einem integrierten Hallsensor 5 auf jeder der Chip-Auflageflächen 3 des Leadframes 1;
B) Verbinden von elektrischen Anschlussflächen 7 der Halbleiterchips 4 mit zugeordneten Anschlussfingern 6 des Leadframes 1 durch Bonddrähte 8;
   Die Fig. 1 zeigt den Zustand nach diesem Schritt, wobei zusätzlich das (noch nicht vorhandene) finale Gehäuse 16 dargestellt ist. In der Fig. 1 sind auch optionale passive Komponenten 18 dargestellt.
C) Platzieren des Leadframes 1 in einer Spritzgussform 9;
   Die Fig. 2 zeigt das in der Spritzgussform 9 platzierte Leadframe 1.
D) Schliessen der Spritzgussform 9 mit einem ersten Formeinsatz, der eine mit Strukturen versehene Formfläche aufweist;
   Diese strukturierte Formfläche ist derjenigen Seite des Leadframes 1 zugewandt, auf der die Halbleiterchips 4 montiert sind.
E) Einspritzen von Kunststoffmaterial in die Spritzgussform 9, um jeden Halbleiterchip 4 und Teile des zugeordneten Leadframeabschnitts 2 in einem zugeordneten Zwischengehäuse 10 zu verpacken, wobei die Strukturen der Formfläche des ersten Formeinsatzes auf jedem Zwischengehäuse 10 eine ebene Fläche 11 mit Alignierungsstrukturen 12 ausbilden;
   Die Alignierungsstrukturen 12 schliessen beispielsweise vier von der ebenen Fläche 11 des Zwischengehäuses 10 abstehende Nocken 13 ein, wie dies in der Fig. 3 dargestellt ist. Die ebene Fläche 11 befindet sich oberhalb des Halbleiterchips 4.
F) Öffnen der Spritzgussform 9;
   Die Fig. 3 zeigt einen einzigen Leadframeabschnitt 2 nach diesem Schritt. Die links und rechts aus dem Zwischengehäuse 10 herausragenden Teile des Leadframeabschnitts 2 sind noch mit dem Leadframe 1 verbunden, dies ist aber aus Gründen der zeichnerischen Klarheit nicht dargestellt.
G) Platzieren je eines Stromleiterabschnitts 15 auf den ebenen Flächen 11 der Zwischengehäuse 10, wobei jeder Stromleiterabschnitt 15 mit zu den Alignierungsstrukturen 12 passenden Gegenstrukturen 14 ausgebildet ist, so dass der Stromleiterabschnitt 15 automatisch ausgerichtet und gehalten wird;
   Die Fig. 4 zeigt den Leadframeabschnitt 2 nach diesem Schritt. Bei dem hier gezeigten Beispiel sind die Gegenstrukturen 14 vier Ausnehmungen, in die die Nocken 13 passgenau, d.h. praktisch ohne Spiel, eingreifen. Ein solcher Stromleiterabschnitt 15 ist in der Fachwelt auch als Stromleiter oder Strombügel bekannt.
H) Schliessen der Spritzgussform 9 mit einem zweiten Formeinsatz;
I) Einspritzen von Kunststoffmaterial in die Spritzgussform 9, um die Stromleiterabschnitte 15 mit dem zugeordneten Zwischengehäuse 10 zu verbinden und die finalen Gehäuse 16 der Stromsensoren 17 zu bilden;
J) Öffnen der Spritzgussform 9 und Herausnehmen des Leadframes 1 aus der Spritzgussform 9;
   Die Fig. 5 zeigt den Leadframeabschnitt 2 nach diesem Schritt. Die links und rechts aus dem Zwischengehäuse 10 herausragenden Teile des Leadframeabschnitts 2 sind - obwohl hier nicht dargestellt - noch mit dem Leadframe 1 verbunden.
   und
K) Vereinzeln der Stromsensoren 17.

Die Leadframeabschnitte 2 sind also bis und mit dem Schritt J mit dem Leadframe 1 verbunden. Bei dem Vereinzeln werden die Stromsensoren 17 von den nicht mehr benötigten Teilen des Leadframes 1 abgetrennt, in der Regel durch einen oder mehrere Stanzprozesse. Wenn gewünscht, werden anschliessend die aus dem Gehäuse 16 herausragenden Anschlussfinger 6 und ebenso die Stromleiterabschnitte 15 abgebogen. Diejenigen Teile der Leadframeabschnitte 2, die die Auflageflächen 3 für den Halbleiterchip 4 mit dem Leadframe 1 verbinden, sind bevorzugt so platziert, dass das Stanzwerkzeug beim Abtrennen dieser Teile an dem Stromleiterabschnitt 15 berührungslos vorbeikommt.

Ein zweites erfindungsgemässes Verfahren umfasst die Schritte A bis F des ersten erfindungsgemässen Verfahrens, wobei die genannte Spritzgussform 9 eine erste Spritzgussform ist, und dann weiter folgende Schritte G bis L, die in der nachfolgend aufgeführten Reihenfolge durchgeführt werden:
G) Herausnehmen des Leadframes 1 aus der ersten Spritzgussform, Transportieren des Leadframes 1 zu einer zweiten Spritzgussform und Platzieren des Leadframes 1 in der zweiten Spritzgussform;
H) Platzieren je eines Stromleiterabschnitts 15 auf den ebenen Flächen 11 der Zwischengehäuse 10, wobei jeder Stromleiterabschnitt 15 mit zu den Alignierungsstrukturen 12 passenden Gegenstrukturen 14 ausgebildet ist, so dass der Stromleiterabschnitt 15 automatisch ausgerichtet und gehalten wird;
I) Schliessen der zweiten Spritzgussform;
J) Einspritzen von Kunststoffmaterial in die zweite Spritzgussform, um die Stromleiterabschnitte 15 mit dem zugeordneten Zwischengehäuse 10 zu verbinden und die finalen Gehäuse 16 der Stromsensoren 17 zu bilden;
K) Öffnen der zweiten Spritzgussform und Herausnehmen des Leadframes 1 aus der zweiten Spritzgussform;
   und
L) Vereinzeln der Stromsensoren 17.

Die zweite Spritzgussform wird geschlossen mit einem Formeinsatz, der der Form der finalen Gehäuse entspricht. Dieser Formeinsatz ist somit gleich dem zweiten Formeinsatz bei dem ersten Verfahren.

Die beiden Verfahren eignen sich auch, um - eines oder mehrere - passive Bauelemente 18 (Fig. 1) in das Gehäuse 16 des Stromsensors 17 zu integrieren. Die passiven Bauelemente 18 können entweder vor dem Schritt C oder D auf dem Leadframe 1 montiert und bei dem Schritt E in das Zwischengehäuse 10 mitverpackt werden, oder bei dem ersten Verfahren vor dem Schritt H auf dem Leadframe 1 montiert und bei dem Schritt I in das finale Gehäuse 16 mitverpackt werden bzw. bei dem zweiten Verfahren vor dem Schritt I auf dem Leadframe 1 montiert und bei dem Schritt J in das finale Gehäuse 16 mitverpackt werden.

Des weiteren kann vor dem Schritt des Platzierens je eines Stromleiterabschnitts 15 auf den ebenen Flächen 11 der Zwischengehäuse 10 ein elektrischer Isolator auf den ebenen Flächen 11 der Zwischengehäuse 10 platziert werden, wobei die Isolatoren mit zu den Alignierungsstrukturen 12 passenden Gegenstrukturen ausgebildet sind und anhand der Alignierungsstrukturen 12 ausgerichtet werden, oder es kann ein elektrisch isolierendes Tape auf dem Stromleiterabschnitt 15 auf der dem Halbleiterchip 4 zugewandten Seite angebracht werden. Des weiteren kann auch die dem Halbleiterchip 4 zugewandte Seite des Stromleiterabschnitts 15 mit elektrisch isolierendem Material beschichtet sein. Die elektrischen Isolatoren bzw. Tapes bzw. diese Schicht bestehen aus einem anderen Material als dem für das Zwischengehäuse 10 und für das finale Gehäuse 16 verwendeten Kunststoffmaterial.

Des weiteren kann nach dem Schritt des Platzierens je eines Stromleiterabschnitts 15 auf den ebenen Flächen 11 der Zwischengehäuse 10 auf jedem Stromleiterabschnitt 15 ein ferromagnetisches Blech platziert werden. Das ferromagnetische Blech dient dazu, das von dem durch den Stromleiterabschnitt 15 fliessenden Strom erzeugte Magnetfeld zu verstärken. Das ferromagnetische Blech und der Stromleiterabschnitt 15 sind mit Vorteil so ausgebildet, dass das ferromagnetische Blech am Stromleiterabschnitt 15 fixierbar ist.

Die Stromleiterabschnitte 15 können - wie dargestellt - Einzelteile sein, die plan oder bereits in eine für die spätere Anwendung geeignete Form gebogen sind. Die Stromleiterabschnitte 15 können aber auch Teil eines weiteren Leadframes sein und werden dann auch im Schritt K bzw. L voneinander getrennt.

Das Kunststoffmaterial, das für die Herstellung der finalen Gehäuse verwendet wird, ist mit Vorteil das gleiche wie das Kunststoffmaterial, das für die Herstellung der Zwischengehäuse verwendet wird.

## Patentansprüche

1. Verfahren zur Herstellung von Stromsensoren, mit den in der nachfolgend aufgeführten Reihenfolge durchgeführten Schritten:
A) Bereitstellen eines Leadframes (1) mit Chip-Auflageflächen (3) und Montieren eines Halbleiterchips (4) mit einem integrierten Hallsensor (5) auf jeder der Chip-Auflageflächen (3) des Leadframes (1),
B) Verbinden von elektrischen Anschlussflächen (7) der Halbleiterchips (4) mit zugeordneten Anschlussfingern (6) des Leadframes (1) durch Bonddrähte (8),
C) Platzieren des Leadframes (1) in einer Spritzgussform (9),
D) Schliessen der Spritzgussform (9) mit einem ersten Formeinsatz, der eine mit Strukturen versehene Formfläche aufweist,
E) Einspritzen von Kunststoffmaterial in die Spritzgussform (9), um jeden Halbleiterchip (4) und zugeordnete Teile des Leadframes (1) in einem zugeordneten Zwischengehäuse (10) zu verpacken, wobei die Strukturen der Formfläche des ersten Formeinsatzes auf jedem Zwischengehäuse (10) eine ebene Fläche (11) mit Alignierungsstrukturen (12) ausbilden,
F) Öffnen der Spritzgussform (9),
G) Platzieren eines Stromleiterabschnitts (15) auf den ebenen Flächen (11) der Zwischengehäuse (10), wobei jeder Stromleiterabschnitt (15) mit zu den Alignierungsstrukturen (12) passenden Gegenstrukturen (14) ausgebildet ist, so dass der Stromleiterabschnitt (15) automatisch ausgerichtet und gehalten wird,
H) Schliessen der Spritzgussform (9) mit einem zweiten Formeinsatz,
I) Einspritzen von Kunststoffmaterial in die Spritzgussform (9), um die Stromleiterabschnitte (15) mit dem zugeordneten Zwischengehäuse (10) zu verbinden und die finalen Gehäuse (16) der Stromsensoren (17) zu bilden,
J) Öffnen der Spritzgussform (9) und Herausnehmen des Leadframes (1) aus der Spritzgussform (9), und
K) Vereinzeln der Stromsensoren (17).

2. Verfahren nach Anspruch 1, weiter umfassend
vor dem Schritt D: Montieren von passiven Bauelementen (18) auf dem Leadframe (1), und
bei dem Schritt E: Mitverpacken der passiven Bauelemente (18) in das Zwischengehäuse (10).

3. Verfahren nach Anspruch 1, weiter umfassend
vor dem Schritt H: Montieren von passiven Bauelementen (18) auf dem Leadframe (1), und
bei dem Schritt I: Mitverpacken der passiven Bauelemente (18) in das finale Gehäuse (16).

4. Verfahren zur Herstellung von Stromsensoren, mit den in der nachfolgend aufgeführten Reihenfolge durchgeführten Schritten:
A) Bereitstellen eines Leadframes (1) mit Chip-Auflageflächen (3) und Montieren eines Halbleiterchips (4) mit einem integrierten Hallsensor (5) auf jeder der Chip-Auflageflächen (3) des Leadframes (1),
B) Verbinden von elektrischen Anschlussflächen (7) der Halbleiterchips (4) mit zugeordneten Anschlussfingern (6) des Leadframes (1) durch Bonddrähte (8),
C) Platzieren des Leadframes (1) in einer ersten Spritzgussform,
D) Schliessen der ersten Spritzgussform mit einem ersten Formeinsatz, der eine mit Strukturen versehene Formfläche aufweist,
E) Einspritzen von Kunststoffmaterial in die erste Spritzgussform, um jeden Halbleiterchip (4) und zugeordnete Teile des Leadframes (1) in einem zugeordneten Zwischengehäuse (10) zu verpacken, wobei die Strukturen der Formfläche des ersten Formeinsatzes auf jedem Zwischengehäuse (10) eine ebene Fläche (11) mit Alignierungsstrukturen (12) ausbilden,
F) Öffnen der ersten Spritzgussform,
G) Herausnehmen des Leadframes (1) aus der ersten Spritzgussform, Transportieren des Leadframes (1) zu einer zweiten Spritzgussform und Platzieren des Leadframes (1) in der zweiten Spritzgussform;
H) Platzieren je eines Stromleiterabschnitts (15) auf den ebenen Flächen (11) der Zwischengehäuse (10), wobei jeder Stromleiterabschnitt (15) mit zu den Alignierungsstrukturen (12) passenden Gegenstrukturen (14) ausgebildet ist, so dass der Stromleiterabschnitt (15) automatisch ausgerichtet und gehalten wird;
I) Schliessen der zweiten Spritzgussform mit einem zweiten Formeinsatz;
J) Einspritzen von Kunststoffmaterial in die zweite Spritzgussform, um die Stromleiterabschnitte (15) mit dem zugeordneten Zwischengehäuse (10) zu verbinden und die finalen Gehäuse (16) der Stromsensoren (17) zu bilden;
K) Öffnen der zweiten Spritzgussform und Herausnehmen des Leadframes (1) aus der zweiten Spritzgussform;
und
L) Vereinzeln der Stromsensoren (17).

5. Verfahren nach Anspruch 4, weiter umfassend
vor dem Schritt D: Montieren von passiven Bauelementen (18) auf dem Leadframe (1), und
bei dem Schritt E: Mitverpacken der passiven Bauelemente (18) in das Zwischengehäuse (10).

6. Verfahren nach Anspruch 4, weiter umfassend
vor dem Schritt I: Montieren von passiven Bauelementen (18) auf dem Leadframe (1), und
bei dem Schritt J: Mitverpacken der passiven Bauelemente (18) in das finale Gehäuse (16).

7. Verfahren nach einem der Ansprüche 1 bis 6, weiter umfassend vor dem Schritt des Platzierens je eines Stromleiterabschnitts (15) auf den ebenen Flächen (11) der Zwischengehäuse (10):
Platzieren je eines elektrischen Isolators auf den ebenen Flächen (11) der Zwischengehäuse (10), wobei der Isolator mit zu den Alignierungsstrukturen (12) passenden Gegenstrukturen (14) ausgebildet ist, so dass der Isolator automatisch ausgerichtet und gehalten wird, oder
Anbringen eines elektrisch isolierenden Tapes auf dem Stromleiterabschnitt (15) auf der dem Halbleiterchip (4) zugewandten Seite.

8. Verfahren nach einem der Ansprüche 1 bis 7, weiter umfassend nach dem Schritt des Platzierens je eines Stromleiterabschnitts (15) auf den ebenen Flächen (11) der Zwischengehäuse (10): Platzieren eines ferromagnetischen Blechs auf jedem Stromleiterabschnitt (15).

9. Verfahren nach einem der Ansprüche 1 bis 8, weiter umfassend
Verwenden eines gleichen Kunststoffmaterials für die Herstellung der Zwischengehäuse (10) und der finalen Gehäuse (16).

## Claims

1. Method for making current sensors, the method comprising the following steps executed in the order given below:
A) providing a leadframe (1) having chip supporting surfaces (3) and mounting a semiconductor chip (4) having an integrated Hall sensor (5) on each of the chip supporting surfaces (3) of the leadframe (1),
B) connecting electrical connection areas (7) of the semiconductor chips (4) with associated connecting fingers (6) of the leadframe (1) by bonding wires (8),
C) placing the leadframe (1) in an injection mold (9),
D) closing the injection mold (9) with a first mold insert having a molding surface provided with structures,
E) injecting plastic material into the injection mold (9) to package each semiconductor chip (4) and associated parts of the leadframe (1) in an associated intermediate housing (10), wherein the structures of the mold surface of the first mold insert form on each intermediate housing (10) a flat surface (11) having alignment structures (12),
F) opening the injection mold (9),
G) placing a current conductor section (15) on the flat surfaces (11) of the intermediate housings (10), wherein each current conductor section (15) is formed with counter structures matching the alignment structures (12), so that the current conductor section (15) is automatically aligned and held,
H) closing the injection mold (9) with a second mold insert,
I) injecting plastic material into the injection mold (9) to connect the current conductor sections (15) with the associated intermediate housing (10) and form the final housings (16) of the current sensors (17),
J) opening the injection mold (9) and removing the leadframe (1) from the injection mold (9), and
K) singulating the current sensors (17).

2. Method according to claim 1, further comprising
before step D: mounting passive components (18) on the leadframe (1), and
in step E: packing also the passive components (18) into the intermediate housing (10).

3. Method according to claim 1, further comprising
before step H: mounting passive components (18) on the leadframe (1), and
in step I: packing also the passive components (18) into the final housing (16).

4. Method for making current sensors, the method comprising the following steps executed in the order given below:
A) providing a leadframe (1) having chip supporting surfaces (3) and mounting a semiconductor chip (4) having an integrated Hall sensor (5) on each of the chip supporting surfaces (3) of the leadframe (1),
B) connecting electrical connection areas (7) of the semiconductor chips (4) with associated connecting terminals (6) of the leadframe (1) by bonding wires (8),
C) placing the leadframe (1) in a first injection mold,
D) closing the first injection mold with a first mold insert having a molding surface provided with structures,
E) injecting plastic material into the first injection mold to package each semiconductor chip (4) and associated parts of the leadframe (1) in an associated intermediate housing (10), wherein the structures of the mold surface of the first mold insert form on each intermediate housing (10) a flat surface (11) having alignment structures (12),
F) opening the first injection mold,
G) removing the leadframe (1) from the first injection mold, transporting the leadframe (1) to a second injection mold and placing the leadframe (1) in the second injection mold;
H) placing a current conductor section (15) on the flat surfaces (11) of the intermediate housings (10), wherein each current conductor section (15) is formed with counter structures matching the alignment structures (12), so that the current conductor section (15) is automatically aligned and held,
I) closing the second injection mold with a second mold insert,
J) injecting plastic material into the second injection mold to connect the current conductor sections (15) with the associated intermediate housing (10) and form the final housings (16) of the current sensors (17),
K) opening the second injection mold and removing the leadframe (1) from the second injection mold, and
L) singulating the current sensors (17).

5. Method according to claim 4, further comprising
before step D: mounting passive components (18) on the leadframe (1), and
in step E: packing also the passive components (18) into the intermediate housing (10).

6. Method according to claim 4, further comprising
before step I: mounting passive components (18) on the leadframe (1), and
in step J: packing also the passive components (18) into the final housing (10).

7. Method according to any of claims 1 to 6, further comprising before the step of placing a current conductor section (15) on the flat surfaces (11) of the intermediate housings (10):
Placing an electrical isolator on the flat surfaces (11) of the intermediate housings (10), wherein each isolator is formed with counter structures matching the alignment structures (12) so that the isolator is automatically aligned and held, or mounting an electrically isolating tape on the current conductor section (15) on a side facing the semiconductor chip (4).

8. Method according to any of claims 1 to 7, further comprising after the step of placing a current conductor section (15) on the flat surfaces (11) of the intermediate housings (10): placing a ferromagnetic sheet of metal on each current conductor section (15).

9. Method according to any of claims 1 to 8, further comprising
Using the same plastic material for making the intermediate housings (10) and the final housings (16).

## Revendications

1. Procédé pour la fabrication de capteurs de courant, avec les étapes effectuées dans l'ordre suivant:
A) mettre à disposition d'une grille de connexion (1) avec des surfaces de support de puce (3) et monter une puce semi-conductrice (4) avec un capteur Hall intégré (5) sur chacune des surfaces de support de puce (3) de la grille de connexion (1),
B) connecter des surfaces de connexion électriques (7) des puces semi-conductrices (4) à des doigts de connexion associés (6) de la grille de connexion (1) par des fils de connexion (8),
C) placer la grille de connexion (1) dans un moule d'injection (9),
D) fermer le moule d'injection (9) avec un premier insert de moule qui présente une surface de moule pourvue de structures,
E) injecter de la matière plastique dans le moule d'injection (9) pour emballer chaque puce semi-conductrice (4) et des parties associées de la grille de connexion (1) dans un boîtier intermédiaire associé (10), les structures de la surface du moule du premier insert du moule formant sur chaque boîtier intermédiaire (10) une surface plane (11) avec des structures d'alignement (12),
F) ouvrir le moule d'injection (9),
G) placer une partie de conducteur de courant (15) sur les surfaces planes (11) des boîtiers intermédiaires (10), chaque partie de conducteur de courant (15) étant formée avec des contre-structures (14) qui sont adaptées aux structures d'alignement (12) afin que la partie de conducteur de courant (15) est automatiquement alignée et soutenue,
H) fermer le moule d'injection (9) avec un deuxième insert de moule,
I) injecter de la matière plastique dans le moule d'injection (9) pour relier les parties de conducteur de courant (15) au boîtier intermédiaire associé (10) et former les boîtiers finals (16) des capteurs de courant (17),
J) ouvrir le moule d'injection (9) et retirer la grille de connexion (1) du moule d'injection (9), et
K) séparer les capteurs de courant (17).

2. Procédé selon la revendication 1 comprenant en outre
avant l'étape D: Monter des composants passifs (18) sur la grille de connexion (1), et
à l'étape E: Emballer aussi les composants passifs (18) dans le boîtier intermédiaire (16).

3. Procédé selon la revendication 1 comprenant en outre
avant l'étape H: Monter des composants passifs (18) sur la grille de connexion (1), et
à l'étape I: Emballer aussi les composants passifs (18) dans le boîtier final (16).

4. Procédé pour la fabrication de capteurs de courant, avec les étapes effectuées dans l'ordre suivant:
A) mettre à disposition d'une grille de connexion (1) avec des surfaces de support de puce (3) et monter une puce semi-conductrice (4) avec un capteur Hall intégré (5) sur chacune des surfaces de support de puce (3) de la grille de connexion (1),
B) connecter des surfaces de connexion électriques (7) des puces semi-conductrices (4) à des doigts de connexion associés (6) de la grille de connexion (1) par des fils de connexion (8),
C) placer la grille de connexion (1) dans un premier moule d'injection (9),
D) fermer le premier moule d'injection (9) avec un premier insert de moule qui présente une surface de moule pourvue de structures,
E) injecter de la matière plastique dans le premier moule d'injection (9) pour emballer chaque puce semi-conductrice (4) et des parties associées de la grille de connexion (1) dans un boîtier intermédiaire associé (10), les structures de la surface du moule du premier insert du moule formant sur chaque boîtier intermédiaire (10) une surface plane (11) avec des structures d'alignement (12),
F) ouvrir le premier moule d'injection (9),
G) retirer la grille de connexion (1) du premier moule d'injection (9), transporter la grille de connexion (1) à un deuxième moule d'injection et placer la grille de connexion (1) dans le deuxième moule d'injection;
H) placer une partie de conducteur de courant (15) sur les surfaces planes (11) des boîtiers intermédiaires (10), chaque partie de conducteur de courant (15) étant formée avec des contre-structures (14) qui sont adaptées aux structures d'alignement (12) afin que la partie de conducteur de courant (15) est automatiquement alignée et soutenue;
I) fermer le deuxième moule d'injection (9) avec un deuxième insert de moule;
J) injecter de la matière plastique dans le deuxième moule d'injection (9) pour relier les parties de conducteur de courant (15) au boîtier intermédiaire associé (10) et former les boîtiers finals (16) des capteurs de courant (17);
K) ouvrir le deuxième moule d'injection (9) et retirer la grille de connexion (1) du deuxième moule d'injection (9); et
L) séparer les capteurs de courant (17).

5. Procédé selon la revendication 4 comprenant en outre
avant l'étape D: Monter des composants passifs (18) sur la grille de connexion (1), et
à l'étape E: Emballer aussi les composants passifs (18) dans le boîtier intermédiaire (16).

6. Procédé selon la revendication 4 comprenant en outre
avant l'étape I: Monter des composants passifs (18) sur la grille de connexion (1), et
à l'étape J: Emballer aussi les composants passifs (18) dans le boîtier final (16).

7. Procédé selon l'une quelconque des revendications 1 à 6, comprenant en outre avant l'étape de placer une partie de conducteur de courant (15) sur les surfaces planes (11) des boîtiers intermédiaires (10):
placer un isolateur électrique sur les surfaces planes (11) des boîtiers intermédiaires (10), l'isolateur étant formé avec des contre-structures (14) qui sont adaptées aux structures d'alignement (12) de sorte que l'isolateur est automatiquement aligné et soutenue, ou fixer une bande électriquement isolante à la partie de conducteur de courant (15) du côté tourné vers la puce semi-conductrice (4).

8. Procédé selon l'une quelconque des revendications 1 à 7, comprenant en outre après l'étape de placer une partie de conducteur de courant (15) sur les surfaces planes (11) des boîtiers intermédiaires (10): placer une feuille ferromagnétique sur chaque partie de conducteur de courant (15).

9. Procédé selon l'une quelconque des revendications 1 à 8, comprenant en outre utiliser d'une même matière plastique pour la fabrication des boîtiers intermédiaires (10) et des boîtiers finaux (16).
